# EUROPEAN PATENT SPECIFICATION

(11) **EP 2 587 793 B1**
(45) Date of publication and mention of the grant of the patent: **08.01.2020**
(21) Application number: 11800842.4
(22) Date of filing: 28.06.2011
(51) Int. Cl.: H04N 5/335, H01L 27/146, H04N 5/225, H05K 1/02

(54) **IMAGE PICKUP DEVICE AND IMAGE-PICKUP DEVICE MODULE**
BILDAUFNAHMEVORRICHTUNG UND MODUL FÜR DIE BILDAUFNAHMEVORRICHTUNG
DISPOSITIF DE CAPTURE D'IMAGE ET MODULE DE DISPOSITIF DE CAPTURE D'IMAGE

(30) Priority: 28.06.2010 JP 2010146463
(43) Date of publication of application: 01.05.2013
(73) Proprietor: Kyocera Corporation, Kyoto 612-8501 (JP)
(72) Inventor: ICHIKI, Shinji, Kyoto 612-8501 (JP); SEGAWA, Hiroyuki, Kyoto 61-8501 (JP)
(74) Representative: Viering, Jentschura & Partner mbB Patent- und Rechtsanwälte
(86) International application number: PCT/JP2011/064794
(87) International publication number: WO 2012/002378

(56) References cited:
- JP-A- 2001 358 997
- JP-A- 2002 134 763
- JP-A- 2005 006 279
- JP-A- 2005 051 015
- JP-A- 2006 147 916
- JP-A- 2007 027 452
- JP-A- 2008 263 552
- US-A1- 2002 105 002
- US-A1- 2009 179 290

## Description

### Technical field

The present invention relates to a wiring substrate for mounting thereon an image sensor of CCD (Charge Coupled Device) type, CMOS (Complementary Metal Oxide Semiconductor) type, or the like, as well as to an image pickup device and an image pickup module.

### Background Art

There is a heretofore known image pickup device applicable to a digital camera, an optical sensor, and so forth, which mounts an image sensor of CCD type, CMOS type, or the like type on a wiring substrate. Such an image pickup device includes: a wiring substrate including an insulating substrate having an opening and a plurality of connection electrodes disposed in a region around the opening so as to surround the opening on the lower surface of the insulating substrate, the plurality of connection electrodes being to electrically connected to an image sensor; and an image sensor. As such an image pickup device, there is known a type in which the image sensor is placed so that its light-receiving section lies inside the opening, and the image sensor is flip-chip mounted on the lower surface of the insulating substrate (refer to Patent literature 1, for example). For example, such an image pickup device is designed to convert light (image) inputted to the light-receiving section of the image sensor through the opening into an electric signal by means of the image sensor, and provide the signal output to an external circuit or the like within a digital camera via a wiring conductor of the wiring substrate and an external terminal.

Such an image pickup device can be made into an image pickup module by attaching a light-transmittable member to the upper surface of the wiring substrate so as to cover the opening for providing protection for the light-receiving section of the image sensor, and placing a lens on the image sensor with the aid of a lens securing member.

In particular, image pickup devices for use in portability-oriented electronic equipment, such as cellular phones and digital cameras, are becoming smaller and smaller in size. Furthermore, in order for a to-be-mounted image sensor to have a higher level of pixel resolution, the proportion in area of the light-receiving section to the image sensor is on the increase.

### Citation List

### Patent Literature

Patent Literature 1: Japanese Unexamined Patent Publication JP-A 2006-201427

Further, document JP 2005 051015 A discloses a circuit board and imaging apparatus having a lower surface surrounding an opening, and document US 2009/0179290 discloses an encapsulated imager packaging.

### Summary of Invention

### Technical Problem

However, in the image pickup device as above described, for the purpose of sealing the light-receiving section for protection, and also, as a bonding material to bond the wiring substrate and the image sensor together, following the completion of mounting of the image sensor on the wiring substrate, a resin is charged in a region between the image sensor and the wiring substrate disposed in overlapping relation in a plan view. As a problem, such a resin is charged from the side of the outer periphery of the image sensor, and, at this time, the resin may spread from the region between the image sensor and the wiring substrate onto the light-receiving section located centrally of the image sensor.

Especially in an image pickup device made smaller in size or made higher in pixel resolution, the distance from the region where the wiring substrate and the image sensor are bonded to each other by the resin to the light-receiving section of the image sensor is increasingly shorter, wherefore the resin tends to spread easily onto the light-receiving section.

The invention has been devised in view of the problem associated with the conventional art as mentioned supra, and accordingly an object of the invention is to provide a wiring substrate which is, at the time of bonding an image sensor, capable of restraining the spread of a resin to a light-receiving section, and also an image pickup device and an image pickup module that employ such a wiring substrate.

### Solution to Problem

Accordingly, the invention provides an image pickup device according to claim 1 and an image pickup module according to claim 7. In accordance with one aspect of the invention, there is provided a wiring substrate including an insulating substrate and a plurality of connection electrodes. The insulating substrate has an opening, and has an inclined area where its lower surface is inclined downward toward the opening. The plurality of connection electrodes are disposed in a surrounding region around the opening on the lower surface of the insulating substrate, and are to be electrically connected to an image sensor.

In accordance with the invention, there is provided an image pickup device including a wiring substrate having the above-described structure and an image sensor. The image sensor is mounted on the lower surface of the insulating substrate of the wiring substrate and is electrically connected to the plurality of connection electrodes.

An image pickup module including an image pickup device having the above-described structure and a lens. The lens is disposed above the opening of the image pickup device.

### Advantageous Effects of Invention

According to the wiring substrate in accordance with one aspect of the invention, since the lower surface of the insulating substrate has the inclined area which is inclined downward toward the opening, it follows that, in charging a resin from a clearance at the side of the outer periphery of the image sensor into a region where the wiring substrate and the image sensor confront each other, the resin is less likely to come out of a small gap at the side of the center of the internal image sensor, which results in a decrease in the possibility of the spread of the resin toward a light-receiving section located centrally of the image sensor.

### Brief Description of Drawings

Fig. 1 is a sectional view showing one embodiment of an image pickup module according to the invention;
Fig. 2(a) is a top view showing one embodiment of a wiring substrate according to the invention, and Fig. 2(b) is a sectional view of the wiring substrate taken along the line A-A of Fig. 2(a);
Fig. 3 is an enlarged sectional view of the main part as the section A depicted in Fig. 2(b) of the construction;
Fig. 4(a) is a top view showing one embodiment of an image pickup device according to the invention, and Fig. 4(b) is a sectional view of the wiring substrate taken along the line A-A of Fig. 4(a);
Fig. 5(a) is a top view showing another embodiment of an image pickup device according to the invention, and Fig. 5(b) is a sectional view of the wiring substrate taken along the line A-A of Fig. 5(a); and
Fig. 6 is a sectional view showing another embodiment of an image pickup device according to the invention.

### Description of Embodiments

Hereinafter, several exemplificative embodiments of the invention will be described with reference to the accompanying drawings.

### <First embodiment>

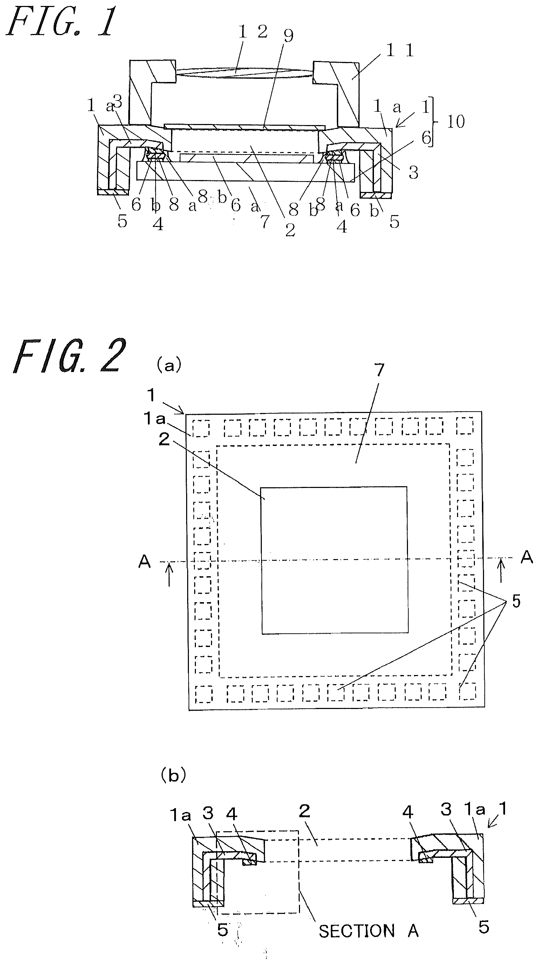

An image pickup module in accordance with a first embodiment of the invention includes, as exemplified in Fig. 1, an image pickup device 10, a lens securing member 11 disposed on the image pickup device 10, and a lens 12 secured by the lens securing member 11.

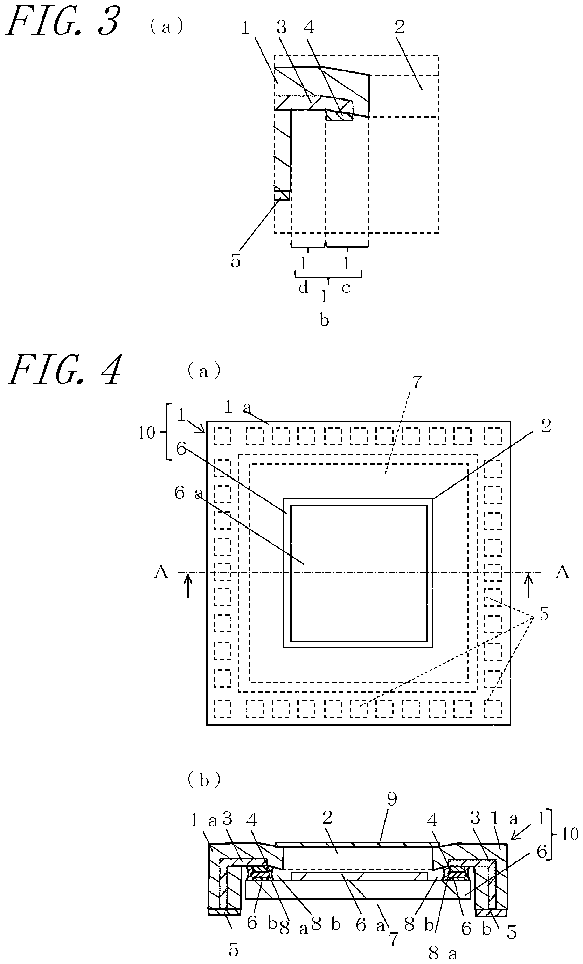

The image pickup device 10 of the first embodiment of the invention includes a wiring substrate 1 and an image sensor 6. The wiring substrate 1 includes, as exemplified in Fig. 2, an insulating substrate 1a having an opening 2 and connection electrodes 4. The connection electrodes 4 are, as exemplified in Fig. 3, disposed in a surrounding region 1b around the opening 2 on the lower surface of the insulating substrate 1a, and are to be connected to the image sensor 6. As exemplified in Fig. 3, the insulating substrate 1a has an inclined area 1c where its lower surface is inclined downward toward the opening 2. Moreover, the insulating substrate 1a has, at its lower surface, a flat area 1d which surrounds the inclined area 1c.

While the opening may be provided in the form of a penetrating hole 2 penetrating through the insulating substrate 1a as exemplified in Fig. 2, the opening may alternatively be provided in the form of a cutout created by cutting away the insulating substrate 1a in the range from part of the side surface to the center thereof.

It is sufficient that the connection electrodes 4 is arranged, for example, face-to-face with each other, with the penetrating hole 2 lying between them, and more preferably, is arranged so as to surround the penetrating hole 2. In the case where the connection electrodes 4 are so arranged as to surround the penetrating hole 2, for example, given that the penetrating hole 2 is rectangular-shaped, then the connection electrodes 4 may be arranged along three sides of the penetrating hole 2 or may be arranged along four sides of the penetrating hole 2.

According to such a wiring substrate 1, in charging a resin acting as a bonding material 8b from a clearance at the side of the outer periphery of the image sensor 6 toward the center thereof so that it reaches a region where the wiring substrate 1 and the image sensor 6 confront each other, the resin is less likely to come out of a small gap at the side of the center of the internal image sensor 6, wherefore the possibility of the spread of the resin toward a light-receiving section 6a located centrally of the image sensor 6 can be decreased.

Moreover, as exemplified in Figs. 1 to 3, the insulating substrate 1a of the wiring substrate 1 may have an inclined area where its upper surface is inclined downward toward the opening 2. With such a configuration, in the case where the inclined areas of the upper surface opposed to each other with the penetrating hole 2 lying therebetween have the same inclination, in placing a light-transmittable member 9 on the inclined area 1c of the upper surface of the insulating substrate 1a so as to cover the penetrating hole 2, the light-transmittable member 9 lies flat and can therefore be placed in a predetermined position.

Moreover, the distance between the light-transmittable member 9 and the light-receiving section 6a of the image sensor 6 can be reduced, and this is effective in decreasing the possibility that an image seen in the light-receiving section 6a will appear blurred.

The insulating substrate 1a constituting the wiring substrate 1 is made of an insulator such as ceramics or resin. In the case where it is made of ceramics, for example, aluminum oxide sintered body (alumina ceramics), aluminum nitride sintered body, mullite sintered body, glass ceramics sintered body, and the like can be used, whereas, in the case where it is made of resin, for example, epoxy resin, polyimide resin, acrylic resin, phenol resin, polyester resin, fluorine resin such as tetrafluoroethylene resin, and the like can be used. In addition, like glass epoxy resin, a material that is impregnated into a base material made of glass fiber can also be used.

In the case where the insulating substrate 1a is made for example of aluminum oxide sintered body, it can be produced by admixing suitable organic solvent and solution medium in powder of a raw material such as alumina (Al₂O₃), silica (SiO₂), calcia (CaO), and magnesia (MgO) to form a slurry, shaping the slurry into a sheet-like form by a heretofore known technique such as the doctor blade method and the calender roll method to obtain a ceramic green sheet, performing appropriate punching operation on the ceramic green sheet and stacking a plurality of ceramic green sheets on top of each other on an as needed basis, and performing firing under a high-temperature condition (in the range of about 1500 to 1800°C). The penetrating hole 2 and a cavity 7 of the wiring substrate 1 can be formed by creating through holes for the penetrating hole 2 and the cavity 7 in a number of ceramic green sheets for the insulating substrate 1a by means of punching using a die or punch, laser machining, or otherwise. Moreover, as exemplified in Figs. 1 to 3, in the case of forming the cavity 7 in the wiring substrate 1, the cavity 7 can be formed by creating a through hole for the cavity 7 in ceramic green sheets in a manner such that the through hole is larger than the through hole for the penetrating hole 2, and stacking the ceramic green sheets on top of each other in layers.

Moreover, where the inclination of the lower surface around the penetrating hole 2 in the wiring substrate 1 is concerned, for example, in the case where the wiring substrate 1 is made of ceramics, the inclination can be obtained by, for example, placing the wiring substrate 1 in a yet-to-be-fired state on a jig which has the same shape as the wiring substrate 1 in a plan view and is inclined toward the center of the penetrating hole 2 and has a large number of holes capable of permeation of gas such as air, and whereafter sucking the lower side of the jig under a reduced pressure by means of a vacuum pump or otherwise. Alternatively, by, for example, placing the wiring substrate 1 in a yet-to-be-fired state on a jig which has the same shape as the wiring substrate 1 in a plan view and is inclined toward the center of the penetrating hole 2 and is made of metal having a high melting point, such as tungsten (W) or molybdenum (Mo), and then firing is performed on the wiring substrate 1 placed on the jig, whereby an inclination conforming to the shape of the jig can be obtained. It is also possible to impart an inclination in stepped form by repeated application of an insulating paste which is substantially the same material as that for the insulating substrate 1a. Note that, in forming a concavity portion around the penetrating hole 2 of the wiring substrate 1, where the concavity portion is made by the application of an insulating paste, it is preferable to, in addition to creating the concavity portion with use of the insulating paste, form a stepped inclination from the standpoint of productivity improvement.

The inclination obtained by such a method is preferably such that the difference in level between the highest and lowest points of the region where the image sensor 6 is bonded to the wiring substrate 1 by the resin acting as the bonding material 8b is about 20 to 30 µm, which is substantially equal to the sum of the thickness of the connection electrode 4 and the thickness of a connecting member 8a. For example, given that the width of the region where the image sensor 6 is bonded to the wiring substrate 1 by the bonding material 8b is 1 mm, then the inclination is about 1.5 to 3°.

Moreover, the inclination is preferably disposed between the connection electrode 4 formed around the through hole and the through hole, or is disposed in a region around the through hole that is free of the connection electrode 4. In such a case, since the connection electrode 4 is not inclined, it follows that a wiring conductor 3 and the image sensor 6 can be electrically connected to each other without fail, and also the distance between the wiring substrate 1 and the image sensor 6 in the connection electrode 4-free region is larger than that in the connection electrode 4-bearing region, wherefore the resin is restrained from spreading therefrom toward the light-receiving section 6a.

In the case where the insulating substrate 1a of the wiring substrate 1 is made for example of resin, it can be formed by means of transfer molding, injection molding, or otherwise with use of a mold capable of providing a predetermined shape of the wiring substrate 1. Moreover, a material that is impregnated into a base material made of glass fiber may also be used. In this case, the insulating substrate can be formed by impregnating a precursor epoxy resin into a base material made of glass fiber and thermally curing the precursor epoxy resin at a predetermined temperature.

When the insulating substrate 1a is made of ceramics, the wiring conductor 3, the connection electrode 4 and the external terminal 5 are made of metalized powder of tungsten (W), molybdenum (Mo), manganese (Mn), silver (Ag), copper (Cu), or the like and is formed at a predetermined position of the wiring substrate 1 by printing a metalized paste for the wiring conductor 3 on a ceramic green sheet for the insulating substrate 1a in a predetermined shape by screen printing or the like and cofiring the metalized paste together with the ceramic green sheet for the insulating substrate 1a. Out of internal conductors, a penetrating conductor penetrating through the ceramic green sheets in a thickness direction thereof may advisably be formed by filling a through hole disposed in the ceramic green sheets with a conductor paste by means of printing. Such a conductor paste is prepared by kneading the above-described metal powder in admixture with suitable solvent and binder while adjusting the viscosity to an appropriate level. Note that, in the interest of enhancement in the strength of the bonding with the wiring substrate 1, the conductor paste may contain glass or ceramics.

When the insulating substrate 1a is made of resin, the wiring conductor 3, the connection electrode 4 and the external terminal 5 are made of metal materials such as copper, gold, aluminum, nickel, chromium, molybdenum, titanium, and alloys thereof. For example, a copper foil processed in the shape of the conductor 3 is transferred onto a resin sheet made of a glass epoxy resin, the resin sheets onto which the copper foil is transferred are stacked and attached by an adhesive. Out of the internal conductors, the penetrating conductor that penetrates in the thickness direction of the resin sheet may be formed by depositing a conductor paste on the inner surface of the through hole that is formed in the resin sheet according to printing or plating or may be formed by filling the through hole. Further, the penetrating conductor is formed by integrating a metal foil and a metal pillar by resin molding or depositing the metal foil on the insulating substrate 1a using sputtering, evaporation, plating, or the like.

The exposed surfaces of the wiring conductor 3, the connection electrode 4, and the external terminal 5 are coated with a plating layer by a plating technique such as electrolytic plating or electroless plating. The plating layer is made of a metal which excels in corrosion resistance and in connectivity with a connection terminal 6b, such as nickel and gold. For example, a nickel plating layer having a thickness of approximately 1 to 10 µm and a gold plating layer having a thickness of approximately 0.1 to 3 µm are deposited one after another. This makes it possible to suppress the wiring conductor 3, the connection electrode 4, and the external terminal 5 from corrosion effectively, as well as to strengthen the bonding between the connection terminal 6b of the image sensor 6 and the connection electrode 4 and the connection between the external terminal 5 and a wiring conductor of an external circuit board.

The mounting of the image sensor 6 on the wiring substrate 1 is, as exemplified in Fig. 1, accomplished by establishing electrical and mechanical connection between an electrode of the image sensor 6 and the connection terminal 6 placed on the wiring substrate 1 via the connecting member 8a such as a solder bump, a gold bump, or an electrically conducting resin (such as an anisotropic conductive resin). Moreover, in this case, after the connection is established via the bump acting as the connecting member 8a, as a so-called underfill, the bonding material 8b made of resin is poured in between the image sensor 6 and the wiring substrate 1. Note that, in the case of using an anisotropic conductive resin as the connecting member 8a, the electrical connection and the bonding between the wiring substrate 1 and the image sensor 6 can be accomplished at the same time.

As the connecting member 8a, a resin material such as epoxy resin and a composite resin composed predominantly of epoxy resin can be used.

Next, the image sensor 6 of CCD type or CMOS type is placed under the wiring substrate 1 so that the light-receiving section 6a can be located inside the penetrating hole 2, and, the electrode of the image sensor 6 and the connection terminal 6 placed on the wiring substrate 1 are electrically and mechanically connected to each other for flip-chip connection via the connecting member 8a such as a solder bump, a gold bump, or an electrically conducting resin (such as an anisotropic conductive resin) so that the connection terminal 6b and the connection electrode 4 can be electrically connected to each other. In such a case, the flip-chip connection can be achieved by means of solder bonding, gold-bump ultrasonic bonding, or anisotropic conductive resin bonding. Note that, in the case of effecting the flip-chip connection using a solder bump or a gold bump, the bonding material 8b is charged for the sake of strengthening the bonding between the connection terminal 6b of the image sensor 6 and the connection electrode 4, and sealing the penetrating hole 2 for the protection of the light-receiving section 6a.

Moreover, as exemplified in Fig. 1, in the image pickup device 10 such as shown hereinabove, a light-transmittable member 9 is attached to the upper surface of the wiring substrate 1 so as to close the penetrating hole 2. In such a structure, it never occurs that moisture or dust finds its way into the penetrating hole 2 and eventually adheres to the light-receiving section 6a of the image sensor 6, wherefore it is possible to provide protection for the image sensor 6, as well as to produce output of high-quality image signals without hindrance to the receiving of light. For example, it is possible to prevent the waste produced when the lens securing member 11 with the lens 12 secured thereto is bonded to the upper surface of the wiring substrate 1 from finding its way into the penetrating hole 2 and from eventually adhering to the light-receiving section 6a of the image sensor 6.

Further, in mounting the image sensor 6 on the wiring substrate 1, it is preferable that, after supporting the wiring substrate 1 so that the connection electrode 4 thereof faces upward, the image sensor 6 is installed thereon from above, and then a resin acting as the bonding material 8b is charged into the region where the wiring substrate 1 and the image sensor 6 confront each other. In such a case, by virtue of the inclination provided at the lower surface (upward-facing surface in this construction) of the wiring substrate 1, the resin flows downward by gravitation and can therefore be restrained from spreading onto the light-receiving section 6a more reliably. In the case where the concavity portion is disposed around the penetrating hole 2 of the wiring substrate 1, likewise, the resin tends to be accumulated inside the concavity portion by gravitation and can therefore be restrained from spreading onto the light-receiving section 6a even more reliably.

The light-transmittable member 9, which is made of quartz, glass, resin such as epoxy resin, or the like, is bonded to the wiring substrate 1 by an adhesive such as thermosetting epoxy resin, ultraviolet-curable epoxy resin or glass. For example, an adhesive made of ultraviolet-curable epoxy resin is applied to the upper surface of the wiring substrate 1 around the through hole or to the outer edge of the light-transmittable member 9 by a dispensing technique, and then the light-transmittable member 9 is placed on the wiring substrate 1 with subsequent ultraviolet irradiation, whereby the adhesive can be cured for sealing of the construction. A filter may be formed on the light-transmittable member 9. In this case, as compared with the case of placing a separately prepared filter on the light-transmittable member 9, the thickness of the image pickup device 10 can be reduced. Accordingly, it is preferable to do so.

As the filter, there is a low-pass filter constructed of a stack of two or three crystal plates of different angles of crystal orientation, which is capable of preventing a moire phenomenon from occurring in an image taken by the image sensor 6 by exploiting the birefringent characteristics of the crystal plates. In the case of using a crystal plate as the light-transmittable member 9, the light-transmittable member 9 is able to serve also as one of the crystal plates of the low-pass filter.

Also, there is an IR cutoff filter for cutting off light in a red to infrared wavelength region, which serves the purpose of adapting the image sensor 6, which generally exhibits higher sensitivity to light in a red to infrared region than do human eyes, to the color-tone sensitivity of human eyes. The IR cutoff filter can be fabricated by forming several dozens of dielectric multilayer films in alternate order on the surface of the light-transmittable member 9. The dielectric multilayer film is customarily formed by stacking several dozens of high-refractive-index dielectric layers made of a dielectric material having a refractive index of greater than or equal to 1.7 and low-refractive-index dielectric layers made of a dielectric material having a refractive index of less than or equal to 1.6 in alternate order by means of vapor deposition, sputtering, or otherwise. Examples of the dielectric material having a refractive index of greater than or equal to 1.7 include tantalum pentoxide, titanium oxide, niobium pentoxide, lanthanum oxide, and zirconium oxide. Examples of the dielectric material having a refractive index of less than or equal to 1.6 include silicon oxide, aluminum oxide, lanthanum fluoride, and magnesium fluoride.

The lens 12, which is made of glass, resin such as epoxy resin, or the like, is attached to the lens securing member 11, and the light which has been transmitted through the lens 12 via the opening of the lens securing member 11 is allowed to enter the light-receiving section 6a. The lens securing member 11 is made of resin, metal, or the like, and is, as exemplified in Fig. 1, fixed to the upper surface of the wiring substrate 1 by an adhesive such as epoxy resin or solder, or fixed to the wiring substrate 1 by a hook or the like formed in advance in the lens securing member 11.

### <Second embodiment>

The image pickup device 10 in accordance with a second embodiment of the invention differs from the first embodiment in that: as exemplified in Fig. 4, the surrounding region 1b of the lower surface of the insulating substrate 1a includes an inclined area 1c surrounding the penetrating hole 2 and a flat area 1d surrounding the inclined area 1c, and a plurality of connection electrodes 4 are arranged on the flat area 1d. Otherwise, the second embodiment is similar in structure to the first embodiment.

In such an image pickup device 10 of the second embodiment, the light-receiving section 6a of the image sensor 6 can be located at the side of the upper surface of the wiring substrate 1, wherefore the distance between the light-transmittable member 9 disposed on the upper surface of the wiring substrate 1 so as to cover the penetrating hole 2 and the light-receiving section 6a can be reduced, which is effective in decreasing the possibility that an image seen in the light-receiving section 6a will appear blurred.

### <Third embodiment>

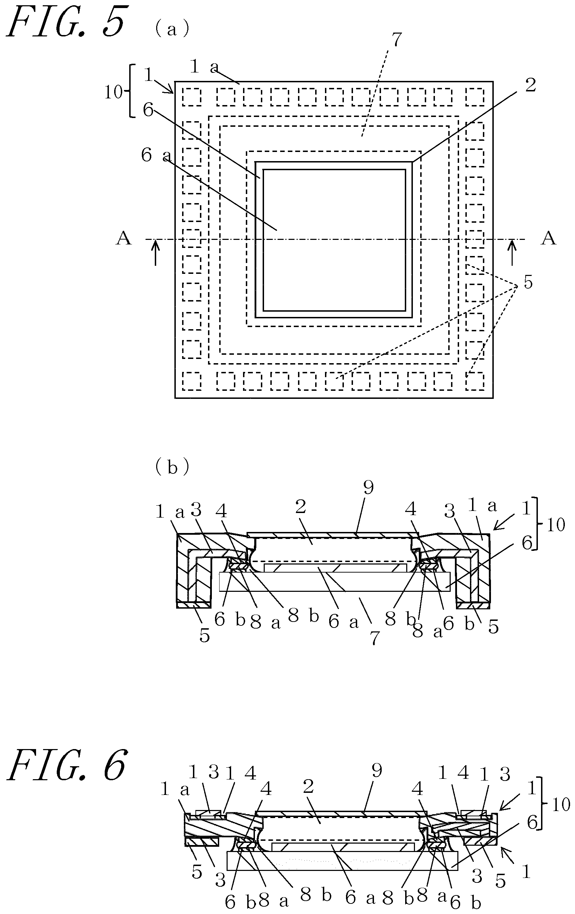

The image pickup device 10 in accordance with a third embodiment of the invention differs from the first embodiment in that: as exemplified in Fig. 5, the insulating substrate 1a has a concavity portion located in, of its lower surface, an edge portion surrounding the penetrating hole 2. Otherwise, the third embodiment is similar in structure to the first embodiment.

In such an image pickup device 10 of the third embodiment, when a resin acting as a bonding material 8b is charged from a clearance at the side of the outer periphery of the image sensor 6 toward the center thereof so as to reach a region where the wiring substrate 1 and the image sensor 6 confront each other, even if the resin finds its way toward the center of the image sensor 6 beyond the region where the wiring substrate 1 and the image sensor 6 confront each other, the resin is accumulated in the concavity portion, which is effective in decreasing the possibility of the spread of the resin toward the light-receiving section 6a.

Moreover, as exemplified in Fig. 5, in the case of forming the concavity portion along the opening at the lower side of the penetrating hole 2 of the wiring substrate 1, the formation can be achieved by creating a first through hole for the penetrating hole 2 in a ceramic green sheet, then creating a second through hole in a different ceramic green sheet from the ceramic green sheet formed with the first through hole so that the second through hole is larger than the first through hole, and stacking these ceramic green sheets on top of each other in layers. Note that each ceramic green sheet may be of a stack of a plurality of ceramic green sheets. In this case, by forming a through hole after the stacking together of a plurality of ceramic green sheets, it is possible to obtain a highly accurate through hole without any influence of sheet misalignment in stacking process. Note that, as exemplified in Fig. 5, in the case where both the concavity portion and the cavity 7 are formed in the wiring substrate 1, it is advisable to form the second through hole so that it is smaller than the through hole for the cavity 7. Moreover, the concavity portion can also be formed by the application of an insulating paste made of a material which is substantially the same as that for ceramic green sheets. In the case of forming the concavity portion with use of the insulating paste, the concavity portion is preferably configured to have a depth of approximately 20 to 30 µm, whereas, in the case of forming the concavity portion with use of ceramic green sheets, the concavity portion is preferably configured to have a depth of approximately 50 µm to 1 mm.

Moreover, as exemplified in Fig. 5, in the case where the concavity portion is formed at a midpoint of the inclination around the penetrating hole 2 of the wiring substrate 1, it is preferable that the concavity portion has its bottom located toward the top side beyond the flat area 1d. This makes it possible to prevent the edge portion of the lower surface of the wiring substrate 1 from colliding against the image sensor 6 when mounting the image sensor 6 on the wiring substrate 1, with the consequent occurrence of breakage of the image sensor 6. Moreover, by imparting an inclination to the concavity portion, it is possible to prevent the spread of the resin onto the light-receiving section 6a of the image sensor 6 more reliably. Accordingly it is preferable to do so.

### <Fourth embodiment>

The image pickup device 10 in accordance with a fourth embodiment of the invention differs from the first embodiment in that: as exemplified in Fig. 6, the insulating substrate 1a has an upper surface including a recess portion 14 for placing an electronic component 13, the recess portion 14 is located around the inclined area 1c in a plan view, and the wiring substrate 1 is shaped like a flat plate. Otherwise, the fourth embodiment is similar in structure to the first embodiment.

Such an image pickup device 10 of the fourth embodiment is effective in decreasing blocking of light which is incident on the light-receiving section 6a caused by adhesion of a bonding material 8b for bonding the electronic component 13 to the wiring substrate 1 to the interior of the penetrating hole 2 or the light-transmittable member 9.

Moreover, since the recess portion 14 is placed in the flat area 1d around the inclined area 1c, it is possible to eliminate the condition that the thickness of the inclined area 1c should be reduced, which is effective in imparting a predetermined inclination to the inclined area 1c.

In forming such a recess portion 14, it is advisable to create a thin film made of an appropriate insulator after forming a connection terminal of the wiring substrate for connection with the electronic component. In the case where the wiring substrate 1 is made of ceramics, the formation can be achieved by applying a ceramic paste which is composed of substantially the same material as the insulating substrate 1a prior to firing process or by applying an organic resin or the like after firing process.

Moreover, since the wiring substrate 1 is configured to have a flat-plate shape, it follows that, when a plurality of green sheets that constitute the wiring substrate 1 are stacked and pressure-bonded together in the course of production of the wiring substrate 1 by a green-sheet lamination method, the sheets as a whole are subjected to pressure of uniform level, wherefore it is possible to suppress accidental distortion of the wiring substrate 1. Further, in the case where the wiring substrate 1 is made of ceramics, in some cases, a load is applied to the wiring substrate 1 for the prevention of occurrence of warpage in the wiring substrate 1 during firing process, and, in this regard, since the outer periphery of the wiring substrate 1 has a flat-plate form, it is easy to apply a load to a predetermined region of the outer periphery of the wiring substrate 1.

The electronic component 13 such as an IC for electric signal processing, a capacitor, a coil or a resistor, is installed through the connection with the wiring conductor 3 by an electrically conducting bonding material 8b such as solder, for example. The electronic component 13 can either be mounted on the wiring substrate 1 after the bonding of the wiring substrate 1 with the image sensor 6, or be mounted on the wiring substrate 1 prior to that bonding operation.

It is noted that, in the wiring substrate 1 having the cavity 7 as exemplified in Figs. 1 to 5, in the case where the electronic component 13 is installed so as to be positioned in overlapping relation to the cavity 7 in a plan view, it is preferable to mount the image sensor 6 on the wiring substrate 1 after the mounting of the electronic component 13 on the wiring substrate 1. This makes it possible to suppress separation of the connection terminal 6b of the image sensor 6 from the connection electrode 4 due to the impact at the time of mounting the electronic component 13.

In the case of mounting the electronic component 13 on the wiring substrate 1, when the electronic component 13 is mounted in the image pickup device 10 including the wiring substrate 1 having the cavity 7 as exemplified in Figs. 1 to 5, in order to suppress occurrence of problem such as breakage, it is preferable to place the wiring substrate 1 on a support plate jig having a projection which conforms to the shape of the penetrating hole 2 of the wiring substrate 1.

Moreover, in the case of mounting the electronic component 13 with solder after the bonding of the wiring substrate 1 with the image sensor 6, it is preferable to mount the electronic component 13 following the completion of attachment of the light-transmittable member 9. This makes it possible to prevent a flux and solder particles contained in a solder cream from scattering around and eventually adhering to the light-receiving section 6a of the image sensor 6.

For example, the image pickup device 10 may be so designed that sidewall portions are formed in vertically or horizontally opposed positions in a plan view, and the image sensor 6 is housed in a vertically or horizontally opened cavity 7 in a plan view. In this case, in bonding the wiring substrate 1 to a wiring substrate, it is possible to achieve the bonding operation while emitting heat and gas generated inside the cavity 7 to the outside, which is effective in preventing deformation of the wiring substrate 1 when it is bonded to the wiring substrate.

Moreover, the inclined area of the lower surface of the wiring substrate 1 around the opening 2 may be either formed around the entire perimeter of the penetrating hole 2 or formed along part of the perimeter. In the case where the region in which the image sensor 6 is bonded to the wiring substrate 1 by the resin acting as the bonding material 8b varies in width from part to part around the perimeter of the penetrating hole 2, the inclination may be formed only in a small-width part of that region at which the bonding material tends to spread toward the light-receiving section 6a. Further, the angle of inclination may be varied in the bonded region in accordance with the width of the bonded region and the position of the connection electrode 4.

### Reference Signs List

- 1:: Wiring substrate
- 1a:: Insulating substrate
- 1b:: Surrounding region
- 1c:: Inclined area
- 1d:: Flat area
- 2:: Penetrating hole
- 3:: Wiring conductor
- 4:: Connection electrode
- 5:: External terminal
- 6:: Image sensor
- 6a:: Light-receiving section
- 6b:: Connection terminal
- 7:: Cavity
- 8a:: Connecting member
- 8b:: Bonding material
- 9:: Light-transmittable member
- 10:: Image pickup device
- 11:: Lens securing member
- 12:: Lens
- 13:: Electronic component
- 14:: Recess portion

## Claims

1. An image pickup device (10), comprising:
a wiring substrate (1), said wiring substrate (1) comprising:
an insulating substrate (1a) having an upper surface, a lower surface and an opening (2) penetrating through the insulating substrate (1a) from the upper surface to the lower surface; and
a plurality of connection electrodes (4) disposed on the lower surface in a surrounding region (1b) surrounding the opening (2), and
an image sensor (6) mounted on the lower surface of the insulating substrate (1a) of the wiring substrate (1) below said opening (2) and electrically connected to the plurality of connection electrodes (4), said image sensor comprising a light receiving section facing said opening (2),
wherein the surrounding region (1b) of said lower surface consists of an inclined area (1c) surrounding the opening (2) and a flat area (1d) surrounding the inclined area (1c),
**characterized by** the inclined area (1c) being inclined downward with respect to the flat area (1d) towards the image sensor (6) and being located between the flat area (1d) and the opening (2) on said lower surface.

2. The image pickup device (10) according to claim 1, wherein the lower surface of the insulating substrate (1a) has a concavity portion located in a part at an edge of the opening (2) .

3. The image pickup device (10) according to claim 1, wherein the plurality of connection electrodes (4) are disposed in the flat area (1d).

4. The image pickup device (10) according to claim 1, wherein the upper surface has a recess portion (14) for placement of an electronic component.

5. The image pickup device (10) according to claim 4, wherein the recess portion (14) is located around the inclined area (1c) in a plan view.

6. The image pickup device (10) according to claim 1, wherein the upper surface has an inclined area which is inclined downward towards the image sensor (6).

7. An image pickup module, comprising:
the image pickup device (10) according to any one of claims 1 to 6; and
a lens (12) disposed above the opening.

## Patentansprüche

1. Eine Bildaufnahmevorrichtung (10), aufweisend:
ein Verdrahtungssubstrat (1), wobei das Verdrahtungssubstrat (1) aufweist:
ein Isoliersubstrat (1a) mit einer oberen Fläche, einer unteren Fläche und einer Öffnung (2), die von der oberen Fläche zur unteren Fläche durch das Isoliersubstrat (1a) hindurchgeht, und
eine Mehrzahl von Verbindungselektroden (4), die auf der unteren Fläche in einem die Öffnung (2) umgebenden Umgebungsbereich (1b) angeordnet sind, und
einen Bildsensor (6), der auf der unteren Fläche des Isoliersubstrats (1a) des Verdrahtungssubstrats (1) unter der Öffnung (2) montiert und elektrisch mit der Mehrzahl von Verbindungselektroden (4) verbunden ist, wobei der Bildsensor einen Lichtempfangsabschnitt aufweist, der der Öffnung (2) zugewandt ist,
wobei der Umgebungsbereich (1b) der unteren Fläche aus einem die Öffnung (2) umgebenden geneigten Bereich (1c) und einem den geneigten Bereich (1c) umgebenden flachen Bereich (1d) besteht,
**dadurch gekennzeichnet, dass** der geneigte Bereich (1c) relativ zu dem flachen Bereich (1d) in Richtung zu dem Bildsensor (6) nach unten geneigt ist und sich zwischen dem flachen Bereich (1d) und der Öffnung (2) auf der unteren Fläche befindet.

2. Die Bildaufnahmevorrichtung (10) gemäß Anspruch 1, wobei die untere Fläche des Isoliersubstrats (1a) einen Konkavitätsabschnitt aufweist, der in einem Teil an einem Rand der Öffnung (2) angeordnet ist.

3. Die Bildaufnahmevorrichtung (10) gemäß Anspruch 1, wobei die Mehrzahl von Verbindungselektroden (4) im flachen Bereich (1d) angeordnet ist.

4. Die Bildaufnahmevorrichtung (10) gemäß Anspruch 1, wobei die obere Fläche einen Aussparungsabschnitt (14) zum Platzieren eines elektronischen Bauelements aufweist.

5. Die Bildaufnahmevorrichtung (10) gemäß Anspruch 4, wobei der Aussparungsabschnitt (14) in einer Draufsicht um den geneigten Bereich (1c) angeordnet ist.

6. Die Bildaufnahmevorrichtung (10) gemäß Anspruch 1, wobei die obere Fläche einen geneigten Bereich aufweist, der in Richtung zu dem Bildsensor (6) nach unten geneigt ist.

7. Ein Bildaufnahmemodul, aufweisend:
die Bildaufnahmevorrichtung (10) gemäß irgendeinem der Ansprüche 1 bis 6 und
eine Linse (12), die über der Öffnung angeordnet ist.

## Revendications

1. Un dispositif de prise d'image (10), comprenant :
un substrat de câblage (1), ledit substrat de câblage (1) comprenant :
un substrat isolant (1a) présentant une surface supérieure, une surface inférieure et une ouverture (2) pénétrant le substrat isolant (1a) de la surface supérieure à la surface inférieure ; et
une pluralité d'électrodes de connexion (4) disposées sur la surface inférieure dans une région environnante (1b) entourant l'ouverture (2), et
un capteur d'image (6) monté sur la surface inférieure du substrat isolant (1a) du substrat de câblage (1) au-dessous de ladite ouverture (2) et connecté électriquement à la pluralité d'électrodes de connexion (4), ledit capteur d'image comprenant une section de réception de lumière orientée vers ladite ouverture (2),
dans lequel la région environnante (1b) de ladite surface inférieure consiste en une zone inclinée (1c) entourant l'ouverture (2) et une zone plate (1d) entourant la zone inclinée (1c),
**caractérisé en ce que** la zone inclinée (1c) est inclinée vers le bas par rapport à la zone plate (1d) vers le capteur d'image (6) et est située entre la zone plate (1d) et l'ouverture (2) sur ladite surface inférieure.

2. Le dispositif de prise d'image (10) selon la revendication 1, dans lequel la surface inférieure du substrat isolant (1a) présente une partie de concavité située dans une partie sur un bord de l'ouverture (2).

3. Le dispositif de prise d'image (10) selon la revendication 1, dans lequel la pluralité d'électrodes de connexion (4) sont disposées dans la zone plane (1d).

4. Le dispositif de prise d'image (10) selon la revendication 1, dans lequel la surface supérieure présente une partie d'évidement (14) pour le placement d'un composant électronique.

5. Le dispositif de prise d'image (10) selon la revendication 4, dans lequel la partie d'évidement (14) est située autour de la zone inclinée (1c) dans une vue en plan.

6. Le dispositif de prise d'image (10) selon la revendication 1, dans lequel la surface supérieure présente une zone inclinée qui est inclinée vers le bas en direction du capteur d'image (6).

7. Un module de prise d'image, comprenant :
le dispositif de prise d'image (10) selon l'une quelconque des revendications 1 à 6 ; et
une lentille (12) disposée au-dessus de l'ouverture.
